(19) Europäisches Patentamt
European Patent Office
Office européen des brevets

(11) **EP 4 120 379 A1**

(12) **EUROPEAN PATENT APPLICATION**
published in accordance with Art. 153(4) EPC

(43) Date of publication:
**18.01.2023 Bulletin 2023/03**

(21) Application number: **20922482.3**

(22) Date of filing: **10.03.2020**

(51) International Patent Classification (IPC):
***H01L 51/44*** *(2006.01)*

(52) Cooperative Patent Classification (CPC):
**H01L 51/442; H01L 51/447;** Y02E 10/542;
Y02E 10/549

(86) International application number:
**PCT/JP2020/010399**

(87) International publication number:
**WO 2021/181542 (16.09.2021 Gazette 2021/37)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **KABUSHIKI KAISHA TOSHIBA**
**Minato-ku**
**Tokyo**
**105-0023 (JP)**

(72) Inventors:
• **MORI, Shigehiko**
**Tokyo**
**1050023 (JP)**

• **NAKAO, Hideyuki**
**Tokyo**
**1050023 (JP)**
• **AMANO, Akio**
**Tokyo**
**1050023 (JP)**
• **TODORI, Kenji**
**Tokyo**
**1050023 (JP)**
• **FUJINAGA, Kenji**
**Kawasaki-shi**
**Kanagawa**
**2120013 (JP)**

(74) Representative: **Hoffmann Eitle**
**Patent- und Rechtsanwälte PartmbB**
**Arabellastraße 30**
**81925 München (DE)**

(54) **PHOTOELECTRIC CONVERSION DEVICE**

(57) A photoelectric conversion device of an arrangement includes: a substrate; a first cell region including a first lower electrode, a first photoelectric conversion layer containing a perovskite compound, and a first upper electrode; a second cell region including a second lower electrode, a second photoelectric conversion layer containing a perovskite compound, and a second upper electrode; and an inter-cell region including a first groove which separates the lower electrodes from each other, a second groove which separates the photoelectric conversion layers from each other, a conductive part which electrically connects the first upper electrode and the second lower electrode, and a third groove which separates the upper electrodes from each other. At least either the substrate including the first and second lower electrodes, or the first and second upper electrodes are formed of a light transmissive material. A member containing at least one of a light reflecting material, a light scattering material, and a light absorbing material, is disposed on the light transmissive material side so as to cover the first groove, the second groove, and a sidewall of the third groove on the first cell region side.

FIG. 1

**Description**

FIELD

Arrangements of the present invention relate to a photoelectric conversion device.

BACKGROUND

In a photoelectric conversion device used for a solar battery, a light emitting element, a photosensor, and so on, a photoelectric conversion cell which uses a perovskite compound as a photoelectric conversion material, is expected as a next-generation photoelectric conversion cell with high efficiency and low cost. For example, regarding efficiency of a solar battery, the efficiency of 25.2% is reported in a perovskite solar battery, which is close to the efficiency of 26.1% of a single crystal silicon solar battery. As a cell configuration using a perovskite compound, it is common to use a stack including, for example, a transparent substrate, a transparent electrode layer, a first intermediate layer, an active layer containing a perovskite compound, a second intermediate layer, and a counter electrode layer. A single photoelectric conversion cell can generate an electromotive force of about 1 V, so that in order to take out a large electromotive force (100 V, for example), plural photoelectric conversion cells are connected in series to be used as a photoelectric conversion module.

For a transparent electrode of a photoelectric conversion cell, a transparent conductive oxide with insufficient conductivity is used. For this reason, as a cell area is increased, a series resistance component of a transparent electrode layer is increased and efficiency for taking out electric charges generated by incident light to the outside is reduced. Accordingly, plural photoelectric conversion cells each having a strip shape with narrow width are formed on a transparent substrate by being arranged side by side, and adjacent cells are connected in series, which makes it possible to suppress an increase in the series resistance component of the photoelectric conversion cells. From such a point as well, a photoelectric conversion module obtained by connecting plural strip-shaped photoelectric conversion cells in series, is expected.

A photoelectric conversion module obtained by connecting plural photoelectric conversion cells in series can be produced by the following method, for example. First, a photoelectric conversion layer is formed on the entire surface of a transparent substrate on which plural transparent electrodes separated by first grooves (separation grooves PI) are formed. Second grooves (separation grooves P2) are formed on the photoelectric conversion layer in accordance with the installation number of photoelectric conversion cells, to thereby expose a part of the transparent electrodes. Next, on the entire surface of the transparent substrate, an electrode film to be a counter electrode is formed. Third grooves (separation grooves P3) are formed on a stacked film of the photoelectric conversion layer and the electrode film in accordance with the installation number of the photoelectric conversion cells to divide the electrode film into plural pieces, to thereby form the counter electrodes. At this time, by electrically connecting the counter electrode of one cell to the transparent electrode of the adjacent cell, the adjacent cells are electrically connected in series.

In the photoelectric conversion module having the configuration as described above, a photoelectric conversion cell which uses a perovskite compound as a photoelectric conversion material has a problem that durability thereof is low. The low durability becomes a large disturbing factor when commercializing the photoelectric conversion cell. Although the durability includes many items, light resistance becomes a problem, in particular, since the photoelectric conversion cell performs an operation through light irradiation or an operation accompanied by light emission, for example. Regarding the light resistance of the photoelectric conversion cell containing the perovskite compound, the light resistance of the perovskite compound itself is a problem. Specifically, in the photoelectric conversion cell, irradiated light is absorbed by a photoelectric conversion layer containing the perovskite compound, and an excited electron-hole pair is separated and flowed from each electrode to an external circuit. A perovskite compound layer generally has a large number of defects, so that a part of photoproduced electric charges is captured by the defect, and by an electric field generated by the captured electric charges, perovskite ions that form the perovskite compound move. By the movement of the perovskite ions, a perovskite composition is decomposed, which generates a hole or a gap in the perovskite layer, and further, when the moved ions react with an intermediate layer or an electrode, properties of the photoelectric conversion cell containing the perovskite compound deteriorate.

In order to prevent the deterioration of properties of the photoelectric conversion cell by suppressing the movement of the perovskite ions, it is reported that, for example, a perovskite composition having a cubic crystal structure with small distortion is adopted, an intermediate layer having a barrier effect is selected so as to suppress movement of perovskite ions to electrodes (a positive electrode and a negative electrode) even if the perovskite ions move in the perovskite layer, and the like. However, even if such a photoelectric conversion cell after taking measures to suppress light deterioration of the perovskite compound is applied, in the photoelectric conversion module obtained by connecting the plural photoelectric conversion cells in series as described above, it is not always possible to obtain a sufficient effect of suppressing the deterioration of properties of the photoelectric conversion cell, and thus the deterioration of cell properties over time cannot be sufficiently suppressed in some cases. Accordingly, it is required to suppress the deterioration of properties due to the light deterioration of the perovskite compound, as a whole photoelectric conversion module.

PRIOR DOCUMENT

PATENT DOCUMENT

Patent Document 1: Japanese Patent No. 6030176

NON-PATENT DOCUMENT

Non-Patent Document 1: H. Tsai et al., Science, 360, 67 (2018)
Non-Patent Document 2: T-Y. Yang et al., Adv. Sci. 6, 1900528 (2019)

SUMMARY OF INVENTION

A problem to be solved by the present invention is to provide a photoelectric conversion device capable of suppressing, when plural photoelectric conversion cells are connected in series to configure a module, deterioration of properties due to light deterioration of a perovskite compound as a whole module.

A photoelectric conversion device of an arrangement includes: a substrate; a first cell region including a first lower electrode provided on the substrate, a first photoelectric conversion layer disposed on the first lower electrode and containing a perovskite compound, and a first upper electrode disposed on the first photoelectric conversion layer; a second cell region including a second lower electrode provided on the substrate so as to be adjacent to the first lower electrode, a second photoelectric conversion layer disposed on the second lower electrode so as to be adjacent to the first photoelectric conversion layer and containing a perovskite compound, and a second upper electrode disposed on the second photoelectric conversion layer so as to be adjacent to the first upper electrode; and an inter-cell region including a first groove provided so as to separate the first lower electrode and the second lower electrode from each other, a second groove provided on the second lower electrode so as to separate the first photoelectric conversion layer and the second photoelectric conversion layer from each other, a conductive part electrically connecting the first upper electrode and the second lower electrode with a conductive material buried in the second groove, and a third groove provided so as to separate at least the first upper electrode and the second upper electrode from each other, in which at least either the substrate including the first lower electrode and the second lower electrode, or the first upper electrode and the second upper electrode are formed of a light transmissive material, and a member containing at least one selected from a group consisting of a light reflecting material, a light scattering material, and a light absorbing material, is disposed on the light transmissive material side so as to cover at least the first groove, the second groove, and a sidewall of the third groove on the first cell region side.

BRIEF DESCRIPTION OF THE DRAWINGS

FIG. 1 is a sectional view illustrating a schematic configuration of a photoelectric conversion device according to a first arrangement.

FIG. 2 is a sectional view illustrating, in an enlarged manner, a photoelectric conversion cell in the photoelectric conversion device illustrated in FIG. 1.

FIG. 3 is a sectional view illustrating a first example of an inter-cell region that exists between first and second cell regions of the photoelectric conversion device illustrated in FIG. 1.

FIG. 4 is a sectional view illustrating a second example of the inter-cell region that exists between the first and second cell regions of the photoelectric conversion device illustrated in FIG. 1.

FIG. 5 is a sectional view illustrating a third example of the inter-cell region that exists between the first and second cell regions of the photoelectric conversion device illustrated in FIG. 1.

FIG. 6 is a sectional view illustrating a schematic configuration of a photoelectric conversion device according to a second arrangement.

FIG. 7 is a sectional view illustrating a first example of an inter-cell region that exists between first and second cell regions of the photoelectric conversion device illustrated in FIG. 6.

FIG. 8 is a sectional view illustrating a second example of the inter-cell region that exists between the first and second cell regions of the photoelectric conversion device illustrated in FIG. 6.

FIG. 9 is a sectional view illustrating a third example of the inter-cell region that exists between the first and second cell regions of the photoelectric conversion device illustrated in FIG. 6.

DETAILED DESCRIPTION

Hereinafter, a photoelectric conversion device of an arrangement will be described with reference to the drawings. Note that in respective arrangements, substantially the same constituent portions are denoted by the same reference signs, and explanation thereof is sometimes partially omitted. The drawings are schematic, and the relation of thickness and planer dimension, a thickness ratio of the respective parts, and so on are sometimes different from actual ones. The term indicating a direction such as an upper or lower direction in the explanation, indicates a relative direction when a forming surface of a photoelectric conversion cell of a substrate to be described later is faced upward, unless otherwise specified, and is sometimes different from an actual direction based on a gravitational acceleration direction.

(First arrangement)

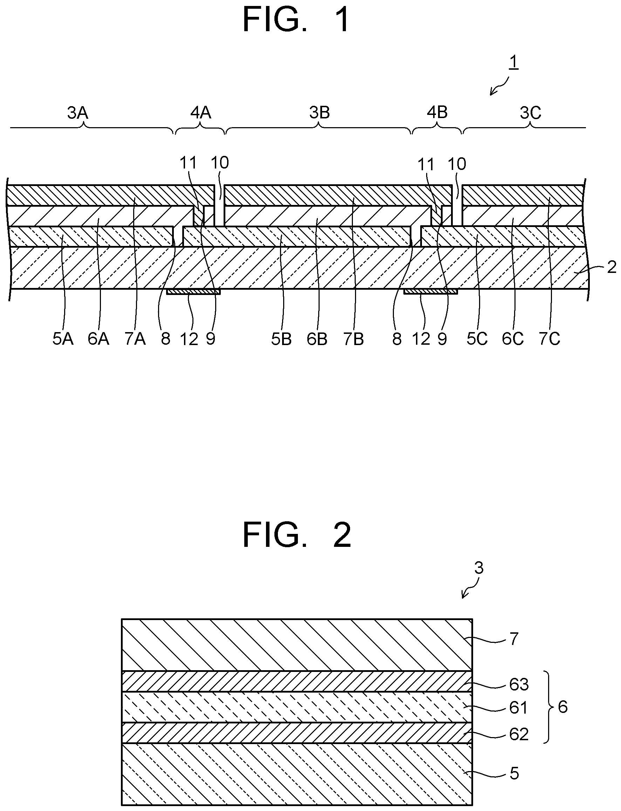

FIG. 1 illustrates a schematic configuration of a photoelectric conversion device 1 of a first arrangement. The photoelectric conversion device 1 illustrated in FIG. 1 includes a substrate 2, plural cell regions 3 (3A, 3B, 3C) provided on the substrate 2, and inter-cell regions 4 (4A, 4B) that exist between these adjacent cell regions 3. The cell regions 3 forming photoelectric conversion cells each include a lower electrode 5 (5A, 5B, 5C), a photoelectric conversion layer 6 (6A, 6B, 6C), and an upper electrode 7 (7A, 7B, 7C) which are formed in order on the substrate 2. In the photoelectric conversion device 1 of the first arrangement, a transparent substrate is applied to the substrate 2, and a transparent electrode is applied to the lower electrode 5.
The transparent substrate 2 is applied and the transparent electrode is used for the lower electrode 5, thereby allowing light to be incident on the photoelectric conversion layer 6 from the substrate 2 side or allowing light to be emitted from the photoelectric conversion layer 6 via the substrate 2, which enables the photoelectric conversion device 1 to function as a photoelectric conversion device of a solar battery, a light emitting element, an optical sensor, or the like. Here, there will be explained an example in which a transparent substrate is used for the substrate 2, a transparent electrode is used for the lower electrode 5, and the upper electrode 7 is set to a counter electrode, but the photoelectric conversion device of the arrangement is not limited to this example. As will be described later in a second arrangement, it is possible to configure the photoelectric conversion device 1 in which a transparent electrode is used for the upper electrode 7, and light is made to be incident on the photoelectric conversion layer 6 from the upper electrode 7 or light is emitted from the photoelectric conversion layer 6 via the upper electrode 7. In this case, the substrate 2 is not limited to the transparent substrate, and it may also be an opaque substrate. Further, each of the substrate 2, the lower electrode 5, and the upper electrode 7 may also be formed of a light transmissive member.
The substrate 2 is formed of a material having, for example, a light transmitting property and an insulating property. As a constituent material of the substrate 2, an inorganic material such as non-alkali glass, quartz glass, or sapphire, or a soft organic material such as polyethylene (PE), polyethylene terephthalate (PET), polyethylene naphthalate (PEN), polyimide, polyamide, polyamide-imide, or a liquid crystal polymer is used. For example, the substrate 2 may be a rigid substrate formed of an inorganic material or an organic material, or may be a flexible substrate formed of an organic material or a very thin inorganic material.
The lower electrode 5 as the transparent electrode is formed of a material having a light transmitting property and conductivity, for example. As the constituent material of the lower electrode 5, it is possible to use a conductive metal oxide material such as indium oxide, zinc oxide, tin oxide, indium tin oxide (ITO), fluorine-doped tin oxide (FTO), gallium-doped zinc oxide (GZO), aluminum-doped zinc oxide (AZO), indium-zinc oxide (IZO), or indium-gallium-zinc oxide (IGZO), a conductive polymeric material such as poly(3, 4-ethylenedioxythiophene)/poly(4-styrenesulfonate) (PEDOT/PSS), and a carbon material such as graphene. The lower electrode 5 may also be composed of a tin oxide film formed by using a conductive glass made of indium, zinc, an oxide, and so on, or the like. The lower electrode 5 may also be a stacked film of a layer formed of any of the aforementioned materials and a metal layer formed of metal such as gold, platinum, silver, copper, cobalt, nickel, indium, or aluminum, or an alloy containing any of these metals, within a range capable of maintaining the light transmitting property. The lower electrode 5 is formed by, for example, a vacuum deposition method, a sputtering method, an ion plating method, a CVD method, a sol-gel method, a plating method, a coating method, or the like. A thickness of the lower electrode 5 is not particularly limited, but is preferably 10 nm or more and 300 nm or less, and more preferably 30 nm or more and 150 nm or less.

As illustrated in FIG. 2, the photoelectric conversion layer 6 has an active layer 61, a first intermediate layer 62 disposed between the lower electrode 5 and the active layer 61, and a second intermediate layer 63 disposed between the active layer 61 and the upper electrode 7. The first intermediate layer 62 and the second intermediate layer 63 are disposed according to need, and all or a part of them may be removed depending on circumstances. The respective layers 61, 62, 63 that form the photoelectric conversion layer 6 are appropriately selected according to a device (a solar battery, a light emitting element, a photosensor, or the like) to which the photoelectric conversion device 1 is applied. Hereinafter, a case where the photoelectric conversion device 1 is used as a solar battery will be mainly described, but the photoelectric conversion device 1 of the arrangement can also be applied to a light emitting element, a photosensor, or the like, and in that case, materials of the respective layers are appropriately selected according to the device to be applied.

For the active layer 61 in the photoelectric conversion device 1 of the arrangement, a perovskite compound having a photoelectric conversion characteristic is used. A typical perovskite crystal particle has a composition represented by the following formula (1), and has a three-dimensional crystal structure.
Composition formula:

$$ABX_3 \ ...(1)$$

In the formula (1), A is a monovalent cation, B is a bivalent cation, and X is a monovalent anion. These will be described later in detail.

The perovskite crystal structure is classified into four types of zero-dimensional structure to three-dimensional structure. A perovskite compound including the two-dimensional structure having a composition represented by $A_2BX_4$ and the three-dimensional structure having a composition represented by $ABX_3$ is advantageous for obtaining a high-efficiency photoelectric conversion material and a photoelectric conversion device 1 using it. Out of the above, the perovskite compound having the three-dimensional structure is known to have a low bound energy of an exciton, and thus is more preferably used for obtaining the high-efficiency photoelectric conversion material and the photoelectric conversion device 1.

It is known to take the two-dimensional structure when an ion radius of an A ion is large and to take the three-dimensional structure when it is small. It is empirically known that when the A ion has an ion radius whose tolerance factor t falls within a range of 0.75 to 1.1, a perovskite-type crystal having a three-dimensional structure is formed. The tolerance factor t is a value expressed by the following formula (2). Although the ion radius includes various types, the ion radius defined by Shannon is used.

$$t = (A \text{ ion radius} + X \text{ ion radius}) / \{2^{1/2} \times (B \text{ ion radius} + X \text{ ion radius})\} \ ...(2)$$

In order to satisfy the A ion condition as described above, a monovalent cation of an amine compound, a monovalent cation of metal, and a mixture of these are used for the A ion. When the A ion is composed of the amine compound, it is preferable to use an organic amine compound such as methyloneammonium ($CH_3NH_4$) and formamidinium ($NH_2CHNH$). When the A ion is composed of metal, it is preferable to use cesium (Cs), rubidium (Rb), potassium (K), lithium (Li), sodium (Na), or the like. For the B ion, a bivalent cation of metal is used. As a metal element composing the B ion, it is preferable to use lead (Pb), tin (Sn), magnesium (Mg), or the like. For the X ion, a monovalent anion of halogen element is used. As the halogen element forming the X ion, it is preferable to use iodine (I), bromine (Br), chlorine (Cl), or the like. Each of the A ion, the B ion, and the X ion is not limited to one material, and may also be a mixture of materials of two kinds or more.

As a method of forming the active layer 61, there can be cited a method in which the above-described perovskite compound or its precursor (which is sometimes described as a perovskite material, hereinafter) is subjected to vacuum deposition, and a method in which a solution obtained by dissolving the perovskite material in a solvent or a dispersion liquid obtained by dispersing the perovskite material in a solvent is coated, followed by heating and drying. As the precursor of the perovskite compound, there can be cited, for example, a mixture of methylammonium halide and lead halide or tin halide. Although a thickness of the active layer 61 is not particularly limited, it is preferably 10 nm or more and 1000 nm or less. As the solvent used for the solution or the dispersion liquid of the perovskite material, there can be cited, for example, N,N-dimethylformamide (DMF), dimethylsulfoxide (DMSO), N-methyl-2-pyrrolidone (NMP), N,N-dimethylacetamide (DMA), acetone, acetonitrile, and the like. Each of these solvents can be used solely or in a mixed manner. There is no particular limitation as long as a solvent capable of uniformly dissolving or dispersing the perovskite material therein is used. As a method of coating the solution or the dispersion liquid to form a film, there can be cited a spin coating method, a dip coating method, a casting method, a bar coating method, a roll coating method, a wire bar coating method, a spray method, a screen printing method, a gravure printing method, a flexographic printing method, an offset printing method, a gravure offset printing method, a dispenser coating method, a nozzle coating method, a capillary coating method, an ink-jet method, and the like, and each of these coating methods can be used solely or in a combined manner.

The first intermediate layer 62 and the second intermediate layer 63 are provided according to need. When, out of electrons and holes generated in the active layer 61, the electrons are collected in the lower electrode 5, the first intermediate layer 62 is formed of a material capable of blocking the holes and selectively and efficiently transporting the electrons. As a constituent material of the first intermediate layer 62 functioning as an electron transport layer, there can be cited an inorganic material such as zinc oxide, titanium oxide, or gallium oxide, an organic material such as polyethyleneimine or its derivative, and a carbon material such as fullerene such as $C_{60}$, $C_{70}$, $C_{76}$, $C_{78}$, or $C_{84}$, or a fullerene derivative such as fullerene oxide obtained by oxidizing at least a part of carbon atoms of fullerene, fullerene hydride such as $C_{60}H_{36}$ or $C_{70}H_{36}$, a fullerene metal complex, [6,6]phenyl$C_{61}$butyric acid methyl ester (60PCBM), [6,6] phenyl$C_{71}$butyric acid methyl ester (70PCBM), or bis-indene C60 (60ICBA), and the constituent material is not particularly limited.

In a case where the holes are collected in the lower electrode 5, the first intermediate layer 62 is formed of a material capable of blocking the electrons and selectively and efficiently transporting the holes. As a constituent material of the first intermediate layer 62 functioning as a hole transport layer, there can be cited an inorganic material such as nickel oxide, copper oxide, vanadium oxide, tantalum oxide, or molybdenum oxide, and an organic material such as polythiophene, polypyrrole, polyacetylene, triphenylenediaminepolypyrrol, polyaniline, a derivative of any of these, or polyethylenedioxythiophene:polystyrenesulfonate (PEDOT:PSS), and the constituent material is not particularly limited.

In a case where, out of the electrons and the holes generated in the active layer 61, the holes are collected in the upper electrode 7, the second intermediate layer 63 is formed of a material capable of blocking the electrons and selectively and efficiently transporting the holes. A constituent material of the second intermediate layer 63 functioning as the hole transport layer is the same as the constituent material of the first intermediate layer 62 as the hole transport layer. In a case where the electrons are collected in the upper electrode 7, the second intermediate layer 63 is formed of a material capable of blocking the holes and selectively and efficiently transporting the electrons. A constituent material of the second intermediate layer 63 functioning as the electron transport layer is the same as the constituent material of the first intermediate layer 62 as the electron transport layer.

The first intermediate layer 62 and the second intermediate layer 63 are formed by, for example, a vacuum deposition method, a sputtering method, an ion plating method, a CVD method, a sol-gel method, a plating method, a coating method, or the like. A thickness of each of the first intermediate layer 62 and the second intermediate layer 63 is preferably 1 nm or more and 200 nm or less. Each of the first intermediate layer 62 and the second intermediate layer 63 may have a structure formed by stacking plural layers, or it is also possible to apply an additional third intermediate layer according to purposes.

The upper electrode 7 functions as a counter electrode of the lower electrode 5 as a transparent electrode. The upper electrode 7 is formed of a material having conductivity, and in some case, having a light transmitting property. As a constituent material of the upper electrode 7, metal such as silver, gold, aluminum, copper, titanium, platinum, nickel, cobalt, iron, manganese, tungsten, zirconium, tin, zinc, indium, chromium, lithium, sodium, potassium, rubidium, cesium, calcium, magnesium, barium, samarium, or terbium, an alloy containing any of these metals, a conductive metal oxide such as ITO or indium-zinc oxide (IZO), a conductive polymer such as PEDOT:PSS, a carbon material such as graphene or carbon nanotube, or the like is used, for example. The upper electrode 7 is formed by an appropriate method according to a material to be used, for example, a vacuum film forming method such as a vacuum deposition method or a sputtering method, a sol-gel method, a coating method, or the like. A thickness of the upper electrode 7 is not particularly limited, but is preferably 1 nm or more and 1 $\mu$m or less.

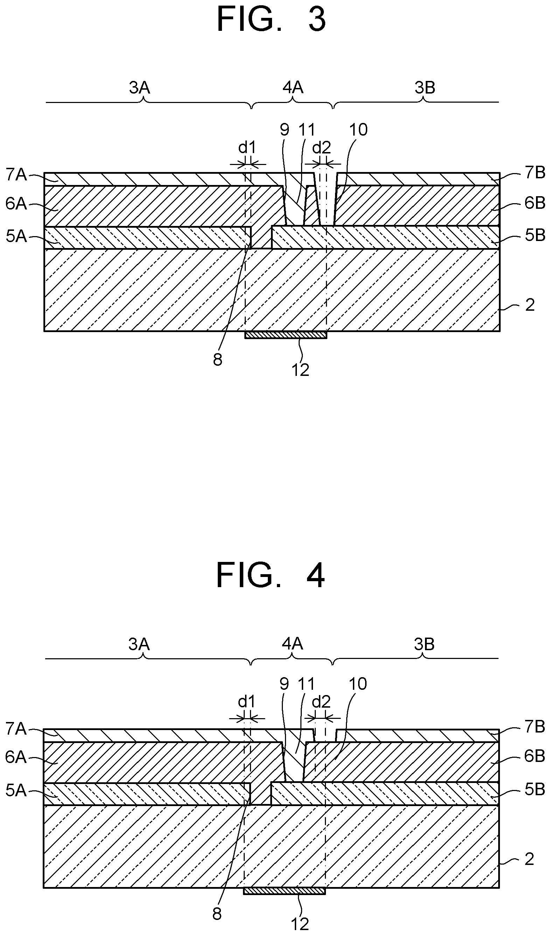

In the photoelectric conversion device 1 of the first arrangement, each of the inter-cell region 4A that exists between the first cell region 3A and the second cell region 3B which are adjacent to each other, and the inter-cell region 4B that exists between the second cell region 3B and the third cell region 3C which are adjacent to each other, has separation grooves which separate the adjacent cell regions 3 from each other, a conductive part which electrically connects the adjacent cell regions 3, and a light shielding part which prevents light irradiation and the like with respect to each of the inter-cell regions 4A, 4B. The inter-cell region 4 will be described by mainly using the inter-cell region 4A that exists between the first cell region 3A and the second cell region 3B as a representative example, while referring to FIG. 3 to FIG. 5. As illustrated in FIG. 3, the inter-cell region 4A has a first groove (separation groove P1) 8 which separates the first lower electrode 5A and the second lower electrode 5B from each other, a second groove (separation groove P2) 9 which separates the first photoelectric conversion layer 6A and the second photoelectric conversion layer 6B from each other, and a third groove (separation groove P3) 10 which separates the first upper electrode 7A and the second upper electrode 7B from each other.

The first groove 8 is provided from upper surfaces of the lower electrodes 5A, 5B to reach a surface of the substrate 2, so as to physically separate adjacent end portions of the first lower electrode 5A and the second lower electrode 5B from each other. At a position between the adjacent end portions of the first lower electrode 5A and the second lower electrode 5B, the surface of the substrate 2 is exposed to the inside of the first groove 8. In the first groove 8, a constituent material of the first photoelectric conversion layer 6A is filled. When the lower electrodes 5A, 5B are formed by patterning, a gap between the patterned lower electrodes 5A and 5B becomes the first groove 8. As a method of patterning the lower electrodes 5A, 5B, there can be cited a method of performing film formation through a sputtering method, a vacuum deposition method, or the like by using a mask. It is also possible to design such that an electrode film is formed on the substrate 2 as a solid film, and then the first groove 8 is formed, to thereby perform patterning of the lower electrodes 5A, 5B. The first groove 8 is formed by mechanical scribing, laser scribing, or the like. It is also possible to apply a method in which patterning is performed through a photolithography method or the like after performing film formation through a sputtering method, a vacuum deposition method, a printing method, or the like, instead of scribing. The same applies to patterning of another layer.

The second groove 9 is provided from upper surfaces of the photoelectric conversion layers 6A, 6B to reach the surface of the second lower electrode 5B, so as to physically separate adjacent end portions of the first photoelectric conversion layer 6A and the second photoelectric conversion layer 6B from each other. The second groove 9 is provided at a position displaced from the first groove 8 toward the second cell region 3B side, so that the position does not overlap with a forming position of the first groove 8. At a position between the adjacent end portions of the first photoelectric conversion layer 6A and the second photoelectric conversion layer 6B, the second lower electrode 5B is exposed to the inside of the second groove 9. In the second groove 9, a part of a constituent material of the first upper electrode 7A is filled to form a conductive part 11, and by the conductive part 11, the first upper electrode 7A and the second lower electrode 5B are electrically connected in series. Specifically, the first cell region 3A and the second cell region 3B which are adjacent to each other are electrically connected in series by the conductive part 11. A photoelectric conversion film is formed, as a solid film, on the substrate 2 including the lower electrodes 5A, 5B, and then the second groove 9 is formed, to thereby perform patterning of the photoelectric conversion layers 6A, 6B. The second groove 9 is formed by mechanical scribing, laser scribing, or the like.

As illustrated in FIG. 3, the third groove 10 is provided from upper surfaces of the upper electrodes 7A, 7B to reach the surface of the second lower electrode 5B, so as to physically separate adjacent end portions of the first upper electrode 7A and the second upper electrode 7B from each other. The third groove 10 may also be provided from the upper surfaces of the upper electrodes 7A, 7B to reach the second photoelectric conversion layer 6B, as illustrated in FIG. 4. At a position between the adjacent end portions of the first upper electrode 7A and the second upper electrode 7B, the surface of the second lower electrode 5B or the second photoelectric conversion layer 6B is exposed to the inside of the third groove 10. In the third groove 10, a sealing material made of an insulating resin or the like, may be filled. When the upper electrodes 7A, 7B are formed by patterning, a gap between the patterned upper electrodes 7A and 7B becomes the third groove 10. In this case, a shape of the third groove 10 becomes a shape as illustrated in FIG. 4. It is also possible to design such that an electrode film is formed on the photoelectric conversion layers 6A, 6B as a solid film, and then the third groove 10 is formed, to thereby perform patterning of the upper electrodes 7A, 7B. The third groove 10 is formed by, for example, mechanical scribing, laser scribing, or the like. In this case, the third groove 10 has a shape as illustrated in FIG. 3 or a shape as illustrated in FIG. 4, based on a depth of the third groove 10.

In the inter-cell region 4A that exists between the first cell region 3A and the second cell region 3B, a light shielding part (light shielding member) 12 is provided so as to cover the first groove 8, the second groove 9, and a sidewall of the third groove 10 on the first cell region 3A side. The light shielding part 12 suppresses light deterioration of the perovskite compound contained in the photoelectric conversion layers 6A, 6B that exist within the inter-cell region 4A. In FIG. 3, the light shielding part 12 is provided on a surface of the substrate 2 on a side opposite to a forming surface of the lower electrode 5 (outer surface). The light irradiation with respect to the perovskite compound contained in the first photoelectric conversion layer 6A that exists in the first groove 8, the first and second photoelectric conversion layers 6A, 6B that exist on both sides of the second groove 9, and the second photoelectric conversion layer 6B that exists on one side of the third groove 10 (the first cell region 3A side), is prevented by the light shielding part 12. This makes it possible to suppress the light deterioration of the perovskite compound contained in these photoelectric conversion layers 6A, 6B.

Here, in a conventional photoelectric conversion cell, measures for suppressing light deterioration of a perovskite compound that exists in a part that mainly performs a photoelectric conversion reaction (a cell region 3, for example) have been taken. Since it is not possible to prevent light irradiation with respect to this part, measures have been conventionally taken for a layer containing the perovskite compound and a layer that is in contact with the layer containing the perovskite compound. These measures have a certain effect, but the present inventors and the like conducted earnest studies and examinations for the pursuit of further suppression of light deterioration, and newly found out that the light deterioration also occurs in the conventional inter-cell region 4 which has not been considered as important.

The inter-cell region 4 is a part on which attention is unlikely to be focused since an area ratio thereof in the photoelectric conversion device 1 is small, and thus a contribution to power generation and the like is quite small. Based on the studies and the examinations conducted by the present inventors and the like, it was found out that the contribution of the inter-cell region 4 to the light deterioration of the perovskite compound cannot be ignored. For example, in a solar battery other than a solar battery containing the perovskite compound, for example, a silicon-type solar battery, such a phenomenon does not occur since silicon itself being a photoelectric conversion layer is stable with respect to light. On the contrary, the perovskite compound is unstable with respect to light as described above, so that it is important to suppress the light deterioration in not only a cell part (power generating part) but also an inter-cell region.

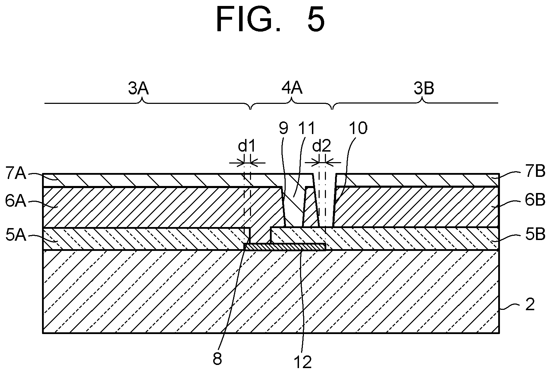

In the photoelectric conversion device 1 according to the first arrangement, the light shielding part 12 is provided on the side of the substrate 2 and the lower electrode 5 which are formed of the light transmissive material, so as to cover the first groove 8, the second groove 9, and the sidewall of the third groove 10 on the first cell region 3A side. Accordingly, it is possible to suppress the light deterioration of the perovskite compound that exists in the inter-cell region 4. In the first arrangement, the light transmissive material is applied to the substrate 2 and the lower electrode 5, so that the light shielding part 12 is provided on the substrate 2 side. FIG. 3 illustrates a state where the light shielding part 12 is provided to the outer surface of the substrate 2. The light shielding part 12 may also be disposed between the substrate 2 and the first and second lower electrodes 5A, 5B, as illustrated in FIG. 5. In this case, the light shielding part 12 is formed of an insulating material. When the light shielding part 12 is provided to the outer surface of the substrate 2, the light shielding part 12 may be formed of either a conductive material or an insulating material, and the material of the light shielding part 12 is appropriately selected according to a forming position of the light shielding part 12.

A forming range of the light shielding part 12 is preferably set in a manner that the light irradiation with respect to the perovskite compound that exists in the inter-cell region 4 is prevented while taking care not to prevent the light irradiation with respect to the cell region 3. Concretely, the forming range of the light shielding part 12 is preferably set so that a distance from an end portion of the light shielding part 12 on the first cell region 3A side to a sidewall of the first groove 8 on the first cell region 3A side (first distance d1) becomes 0.1 mm or more and 3 mm or less. Further, it is preferable to set the forming range of the light shielding part 12 so that a distance from an end portion of the light shielding part 12 on the second cell region 3B side to a sidewall of the third groove 10 on the first cell region 3A side (second distance d2) becomes 0.1 mm or more and 3 mm or less. Each of the first and second distances d1, d2 is more preferably 0.5 mm or less.

For the light shielding part 12, a member containing at least one selected from a group consisting of a light reflecting material, a light scattering material, and a light absorbing material is applied. As the light reflecting material, there can be cited a metal material, for example. As such a metal material, aluminum, an aluminum alloy, gold, silver, copper, stainless steel, chromium, nickel, zinc, titanium, tantalum, molybdenum, a chromium-molybdenum alloy, a nickel-molybdenum alloy, or the like is used. The light shielding part 12 is not limited to a plate-shaped member, and it may also be a coating layer of a resin paste or the like containing powder of the metal material, or the like. The configuration of the light shielding part 12 is not particularly limited as long as it can reflect light.

As the light scattering material, there can be cited a metal oxide material, for example. As such a metal oxide material, there can be cited titanium oxide, aluminum oxide, calcium oxide, zinc oxide, zirconium oxide, barium sulfate, barium stearate, and the like. However, it is also possible to apply a material other than the metal oxide material as long as a light scattering effect can be obtained. The light shielding part 12 is not limited to a plate-shaped member, and it may also be a coating layer of a resin paste or the like containing powder of the metal oxide material, or the like. The configuration of the light shielding part 12 is not particularly limited as long as it can scatter light.

As the light absorbing material, there can be cited a coloring agent, for example, As the coloring agent, there can be cited a coloring agent of black color, and a coloring agent of chromatic color such as red, green, blue, or white. As the coloring agent of black color, there can be cited an inorganic pigment of a blackish metal oxide such as carbon black, titanium black, or black iron oxide, a metal sulfide such as bismuth sulfide, or the like, and an organic pigment of phthalocyanine black, nigrosine, aniline black, perylene black, or the like. As the coloring agent of chromatic color, there can be cited an inorganic pigment of chromatic color and an organic pigment of chromatic color. The light shielding part 12 containing any of these coloring agents is used as a coating layer of a resin paste containing the coloring agent, a resin body (a plate material, for example) containing the coloring agent, or the like.

A thickness of the light shielding part 12 is preferably one with which light is perfectly shielded, but it may also be one with which a part of light is shielded. The thickness of the light shielding part 12 is not limited in particular, and is appropriately selected according to the forming material or the like of the light shielding part 12. Note that when the light shielding part 12 is formed on the substrate 2, the thickness of the light shielding part 12 is preferably about the same as or smaller than the thickness of the lower electrode 5. This makes it possible to form the photoelectric conversion layer 6 containing the perovskite compound, as a uniform continuous film, on the light shielding part 12 and the lower electrode 5.

A method of forming the light shielding part 12 is not particularly limited as long as it is a method capable of shielding at least a part of light irradiation with respect to the photoelectric conversion layer 6 containing the perovskite compound, and is appropriately selected according to the forming material of the light shielding part 12. The light shielding part 12 may be formed by a method in which film formation is performed through a sputtering method, a vacuum deposition method, or the like using a mask, a method in which film formation is performed through a sputtering method, a vacuum deposition method, or the like, and then patterning is performed through a photolithography method or the like, or a film forming method such as a printing method, an ink-jet method, a transfer method, an electric field plating method, or an electroless plating method, and the light shielding part 12 may also be formed by attaching a plate material, a film, or the like of the forming material thereof.

By providing the light shielding part 12 to the inter-cell region 4, the following effects can be expected. By providing the light shielding part 12 so as to cover the first groove 8, the second groove 9, and the sidewall of the third groove 10 on the first cell region 3A side, the light resistance of the perovskite compound that exists in the inter-cell region 4 is improved. The light deterioration in the inter-cell region 4 when the light irradiation is performed on the photoelectric conversion device 1 which is not provided with the light shielding part 12 and which contains the perovskite compound, occurs as follows.

First, the light deterioration in the first groove (separation groove P1) 8 occurs as follows. The incident light is absorbed by a layer containing the perovskite compound, and separation of excited electron-hole pair occurs. One electric charge flows through the upper electrode (counter electrode) 7, but the other electric charge accumulates in the vicinity of an interface of the first groove 8 with respect to the substrate 2 (a perovskite compound-containing layer side) since the lower electrode (transparent electrode) 5 does not exist because of the first groove 8, and due to the accumulated electric charges, electric charge intensity becomes large. Accordingly, perovskite ions forming the perovskite compound-containing layer move, resulting in that a hole or a gap is generated in the perovskite compound-containing layer. For this reason, halogen (iodine, for example) reacts with the upper electrode 7, which deteriorates the upper electrode 7.

In the second groove (separation groove P2) 9, halogen in the perovskite compound-containing layer reacts with the constituent material of the upper electrode 7 in the second groove 9 which is not covered by the photoelectric conversion layer 6 (the second intermediate layer 63, for example), which deteriorates the upper electrode 7. Further, this reaction is accelerated when the movement of ions is facilitated by the light irradiation. In the third groove (separation groove P3) 10, the unstable perovskite compound-containing layer is exposed, so that the light deterioration is likely to occur. Further, this reaction is accelerated when the movement of ions is facilitated by the light irradiation. By suppressing the above-described light deterioration of the perovskite compound that exists in the inter-cell region 4 with the use of the light shielding part 12, it is possible to suppress the deterioration of properties of the photoelectric conversion device 1 containing the perovskite compound, namely, the deterioration of properties of the photoelectric conversion device 1 having plural cell regions (photoelectric conversion cells) 3 which are electrically connected in series. Therefore, it becomes possible to provide the photoelectric conversion device 1 capable of maintaining properties over time.

(Second arrangement)

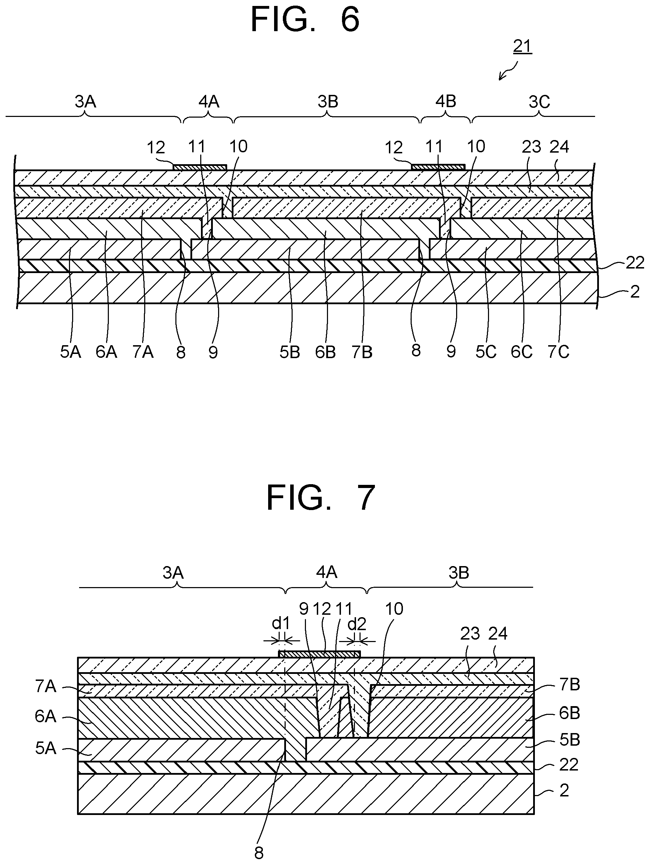

FIG. 6 illustrates a schematic configuration of a photoelectric conversion device 21 of a second arrangement. The photoelectric conversion device 21 illustrated in FIG. 6 includes a substrate 2, an insulating layer 22 provided on the substrate 2, plural cell regions 3 (3A, 3B, 3C) provided on the insulating layer 22, and inter-cell regions 4 (4A, 4B) that exist between these adjacent cell regions 3. The cell regions 3 forming photoelectric conversion cells each include a lower electrode 5 (5A, 5B, 5C), a photoelectric conversion layer 6 (6A, 6B, 6C), and an upper electrode 7 (7A, 7B, 7C) which are formed in order on the substrate 2 having the insulating layer 22. On the upper electrode 7 of the cell region 3 and the inter-cell region 4, a sealing layer 23 and a sealing substrate 24 are disposed. In the photoelectric conversion device 21 of the second arrangement, the upper electrode 7 employs a light transmissive material, namely, a transparent electrode. For this reason, the light transmissive material is applied also to the sealing layer 23 and the sealing substrate 24.

The transparent electrode is used for the upper electrode 7, and the light transmissive material is applied also to the sealing layer 23 and the sealing substrate 24, thereby allowing light to be incident on the photoelectric conversion layer 6 from the upper electrode 7 side or allowing light to be emitted from the photoelectric conversion layer 6 via the upper electrode 7, the sealing layer 23, and the sealing substrate 24, which enables the photoelectric conversion device 21 to function as a photoelectric conversion device of a solar battery, a light emitting element, an optical sensor, or the like. When applying the transparent electrode to the upper electrode 7, a constituent material of the upper electrode 7 employs one same as that of the lower electrode 5 in the photoelectric conversion device 1 of the first arrangement. A constituent material, a composing layer, and so on of the photoelectric conversion layer 6 are the same as those of the photoelectric conversion device 1 of the first arrangement.

The substrate 2 may be formed of, for example, a non-light transmitting material or a light transmitting material. Concrete examples of the light transmitting material are as explained in the first arrangement. As the non-light transmitting material, there can be cited, for example, a metal sheet such as an aluminum sheet, a resin sheet used for a general substrate, and the like. A configuration example of the resin sheet is the same as that of the first arrangement. When the substrate 2 is formed of the non-light transmitting material, the insulating layer 22 such as a nonconductive resin layer is disposed on the substrate 2, as illustrated in FIG. 6. When the lower electrode 5 is set to a counter electrode, a constituent material of the lower electrode 5 employs one same as that of the upper electrode 7 in the photoelectric conversion device 1 of the first arrangement.

The sealing layer 23 protects the upper electrode 7, the photoelectric conversion layer 6, and so on when using the transparent electrode for the upper electrode 7. The sealing layer 23 uses a transparent resin material, similarly to a general electronic device, and a material thereof is not particularly limited. The same applies to the sealing substrate 24, and it functions as a protective material of the upper electrode 7, the photoelectric conversion layer 6, and so on. A transparent substrate is applied to the sealing substrate 24, and a transparent resin film such as a PET film, for example, is used. The constituent material of the sealing substrate 24 can employ a material and a configuration same as those of the substrate (transparent substrate) 2 in the first arrangement.

In the photoelectric conversion device 21 of the second arrangement, each of the inter-cell region 4A that exists between the first cell region 3A and the second cell region 3B which are adjacent to each other, and the inter-cell region 4B that exists between the second cell region 3B and the third cell region 3C which are adjacent to each other, has separation grooves 8, 9, 10 each of which separates the adjacent cell regions 3 from each other, a conductive part 11 which electrically connects the adjacent cell regions 3, and a light shielding part 12 which prevents light irradiation and the like with respect to each of the inter-cell regions 4A, 4B, similarly to the first arrangement. The configurations of the first groove 8, the second groove 9, the third groove 10, and the conductive part 11 in the inter-cell region 4 are the same as those of the first arrangement.

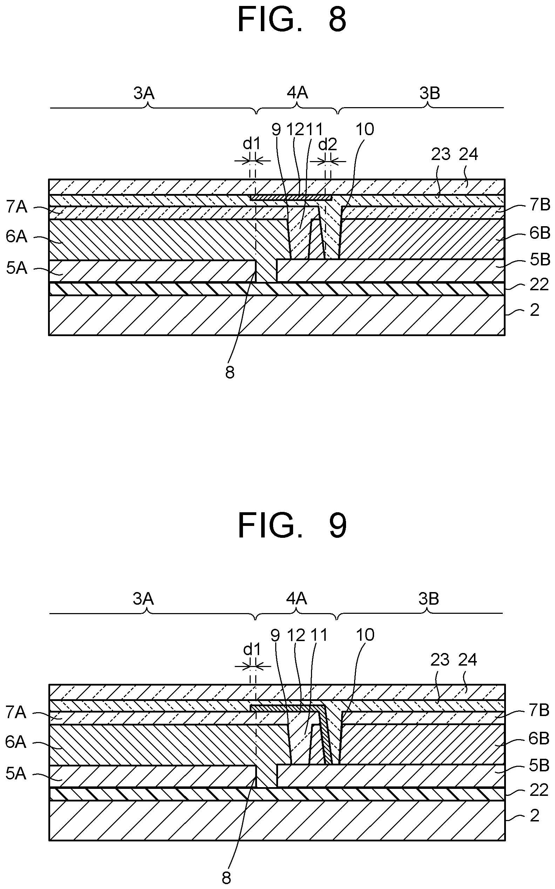

The light shielding part 12 provided in the inter-cell region 4, is provided on the upper electrode 7 side so as to prevent light irradiated via the upper electrode 7, the sealing layer 23, and the sealing substrate 24 from reaching the perovskite compound that exists in the inter-cell region 4. FIG. 7 illustrates a state in which the light shielding part 12 is disposed on the sealing substrate 24. FIG. 8 illustrates a state in which the light shielding part 12 is disposed between the sealing layer 23 and the sealing substrate 24. In these cases, the light shielding part 12 may be formed of either a conductive material or an insulating material. FIG. 9 illustrates a state in which the light shielding part 12 is provided so as to cover from an upper portion of the upper electrode 7 to a sidewall of the third groove 10 on the cell region 3A side. In this case, the light shielding part 12 is formed of an insulating material. The configurations such as a forming material, a forming range, a thickness, and a forming method of the light shielding part 12 are preferably the same as those of the first arrangement.

Also in the second arrangement, by suppressing the light deterioration of the perovskite compound that exists in the inter-cell region 4 with the use of the light shielding part 12, similarly to the first arrangement, it is possible to suppress the deterioration of properties of the photoelectric conversion device 21 containing the perovskite compound, namely, the deterioration of properties of the photoelectric conversion device 21 having the plural cell regions (photoelectric conversion cells) 3 which are electrically connected in series. Therefore, it becomes possible to provide the photoelectric conversion device 21 capable of taking out a large electromotive force by connecting the plural cell regions (photoelectric conversion cells) 3 in series, and capable of maintaining properties over time after increasing the efficiency of taking out generated electric charges to the outside.

EXAMPLES

Next, examples and evaluation results thereof will be described.

(Example 1)

On a glass substrate with a thickness of 0.7 mm, plural 150 nm-thick ITO films were formed as transparent electrodes, to thereby produce an ITO substrate. The number of the ITO films formed was eight corresponding to the number of photoelectric conversion cells installed. That is, they were formed so as to correspond to an eight-series module. A surface of the ITO substrate was irradiated with ultraviolet ozone (UV-O3) to remove contamination due to an organic matter on the surface of the ITO substrate. Next, a forming solution for a hole transport layer (a first intermediate layer) was prepared by adding 1 mL of pure water to 1 mL of PEDOT:PSS. This hole transport layer solution was coated onto the ITO substrate, heating was then performed in the atmosphere at 140°C for 10 minutes to remove an excess solvent, to thereby form the hole transport layer. A film thickness of the hole transport layer is about 50 nm. For PEDOT:PSS, AI4083 (product name) manufactured by Heraeus K.K., was used.

Next, a perovskite material solution was prepared as follows. A first perovskite material solution was prepared by adding 0.91 mL of dimethylformamide (DMF) and 0.09 mL of dimethyl sulfoxide (DMSO) to 461 mg of lead iodine ($PbI_2$). A second perovskite material solution was prepared by adding 12.33 mL of isopropyl alcohol to 900 mg of methylammonium iodide ($CH_3NH_3I$ (MAI)). The first perovskite material solution was coated to form a $PbI_2$ film. This $PbI_2$ film was naturally dried under a nitrogen atmosphere, the second perovskite material solution was then coated onto

the PbI$_2$ film, heating was then performed under a nitrogen atmosphere at 120°C for 10 minutes to remove an excess solvent and facilitate a reaction between PbI$_2$ and MAI, to thereby obtain a MAPbI$_3$ film. A film thickness of the MAPbI$_3$ film is about 350 nm.

A solution for a first electron transport layer (a second intermediate layer) was prepared by adding 1 mL of monochlorobenzene to 20 mg of 60PCBM. This solution was coated onto the perovskite layer, and heating was performed under a nitrogen atmosphere at 100°C for 10 minutes to remove an excess solvent, to thereby form a 60PCBM layer. A film thickness of the 60PCBM layer is about 100 nm. Next, P2 scribing was performed by mechanical scribing. As a scribing tool, an 80 $\mu$m-wide cutting tool having a rectangular tip was used. In the P2 mechanical scribing, the scribing tool was pressed by a suspension mechanism using a spring and was scanned in a direction parallel to a longitudinal direction of the ITO film, and three layers of the 60PCBM layer, the perovskite layer, and the hole transport layer were scraped to expose the ITO films.

Next, as a second electron transport layer (a third intermediate layer), BCP (2,9-dimethyl-4,7-diphenyl-1,10-phenanthroline) was deposited by vacuum deposition. A film thickness of the BCP layer is about 20 nm. Subsequently, as a counter electrode, Ag was deposited by vacuum deposition. A film thickness of the Ag layer is about 150 nm. A common deposition mask was used for both layers of the BCP layer and the Ag layer, and eight BCP layers and eight Ag layers were formed corresponding to the number of the photoelectric conversion cells installed. Consequently, an eight-series module structure was formed. An area of one photoelectric conversion cell is about 2.8 cm$^2$.

A light shielding part was provided to the perovskite solar battery module produced as described above. A procedure thereof will be described below. A black stainless steel sheet with a thickness of 0.3 mm was attached to the outside of the glass substrate so as to cover a position corresponding to an inter-cell region (scribe portion). A light shielding range of the stainless steel sheet was from a position on the outer side by 0.5 mm from a left end of the separation groove P1, being a starting point, to a position on the outer side by 0.5 mm from a right end of the separation groove P3. As a method of blackening the stainless steel sheet being the light shielding part, a black electroless nickel plating method was used. A film thickness of the black coating film is about 10 $\mu$m.

Next, a light irradiation test was performed. The perovskite solar battery module was irradiated with metal halide lamp light whose radiation intensity was set to 100 mW/cm$^2$ for 500 h, and a change in efficiency before and after the light irradiation test was examined. An efficiency maintenance ratio of the perovskite solar battery module after the light irradiation test was 58%.

(Example 2)

A perovskite solar battery module was produced in the same manner as in Example 1, except that a place of installing the light shielding part was changed from the outside of the glass substrate to a position on the glass substrate. A procedure of forming the light shielding part is as follows. At a position corresponding to the inter-cell region (scribe portion), a 100 nm-thick carbon black paste was coated by a screen printing method. A light shielding range of the carbon black paste being the light shielding part was from a position on the outer side by 0.5 mm from a left end of the separation groove P1, being a starting point, to a position on the outer side by 0.5 mm from a right end of the separation groove P3.

Next, a light irradiation test was performed. The perovskite solar battery module was irradiated with metal halide lamp light whose radiation intensity was set to 100 mW/cm$^2$ for 500 h, and a change in efficiency before and after the light irradiation test was examined. An efficiency maintenance ratio of the perovskite solar battery module after the light irradiation test was 50%.

(Comparative example 1)

A perovskite solar battery module was produced in the same manner as in Example 1, except that the light shielding part was not provided. Next, a light irradiation test was performed. The perovskite solar battery module was irradiated with metal halide lamp light whose radiation intensity was set to 100 mW/cm$^2$ for 500 h, and a change in efficiency before and after the light irradiation test was examined. An efficiency maintenance ratio of the perovskite solar battery module after the light irradiation test was 27%.

As indicated by Examples 1, 2, and Comparative example 1, it can be understood that the module with improved light resistance can be obtained by providing the light shielding part. Further, in the module to which the light shielding part was not provided, a color change occurred in a range from the separation groove P1 to the separation groove P3, but in the module provided with the light shielding part, a color change was not recognized in the range from the separation groove P1 to the separation groove P3. As described above, it is possible to obtain the photoelectric conversion module with improved light resistance, by providing the light shielding part.

While certain arrangements of the present invention have been described, these arrangements have been presented by way of example only, and are not intended to limit the scope of the inventions. Indeed, the novel arrangements described herein may be embodied in a variety of other forms; furthermore, various omissions, substitutions and changes may be made without departing from the spirit of the inventions. The inventions described in the accompanying claims and their equivalents are intended to cover such forms or modifications as would fall within the scope and spirit of the inventions.

REFERENCE SIGNS LIST

1, 21...photoelectric conversion device, 2...substrate, 3, 3A, 3B, 3C...cell region, 4, 4A, 4B...inter-cell region, 5, 5A, 5B, 5C...lower electrode, 6, 6A, 6B, 6C...photoelectric conversion layer, 61...active layer, 7, 7A, 7B, 7C...upper electrode, 8...first groove, 9...second groove, 10...third groove, 11...connecting part, 12...light shielding part, 22...insulating layer, 23...sealing layer, 24...sealing substrate

**Claims**

1. A photoelectric conversion device, comprising:

   a substrate;
   a first cell region including a first lower electrode provided on the substrate, a first photoelectric conversion layer disposed on the first lower electrode and containing a perovskite compound, and a first upper electrode disposed on the first photoelectric conversion layer;
   a second cell region including a second lower electrode provided on the substrate so as to be adjacent to the first lower electrode, a second photoelectric conversion layer disposed on the second lower electrode so as to be adjacent to the first photoelectric conversion layer and containing a perovskite compound, and a second upper electrode disposed on the second photoelectric conversion layer so as to be adjacent to the first upper electrode; and
   an inter-cell region including a first groove provided so as to separate the first lower electrode and the second lower electrode from each other, a second groove provided on the second lower electrode so as to separate the first photoelectric conversion layer and the second photoelectric conversion layer from each other, a conductive part electrically connecting the first upper electrode and the second lower electrode with a conductive material buried in the second groove, and a third groove provided so as to separate at least the first upper electrode and the second upper electrode from each other, wherein:

      at least either the substrate including the first lower electrode and the second lower electrode, or the first upper electrode and the second upper electrode are formed of a light transmissive material; and
      a member containing at least one selected from a group consisting of a light reflecting material, a light scattering material, and a light absorbing material, is disposed on the light transmissive material side so as to cover at least the first groove, the second groove, and a sidewall of the third groove on the first cell region side.

2. The photoelectric conversion device according to claim 1, wherein:

   the substrate including the first and second lower electrodes is formed of the light transmissive material; and
   the member is disposed on a surface of the substrate on a side opposite to a surface on which the first and second lower electrodes are provided.

3. The photoelectric conversion device according to claim 1, wherein:

   the substrate including the first and second lower electrodes is formed of the light transmissive material; and
   the member is disposed between the substrate and the first and second lower electrodes.

4. The photoelectric conversion device according to claim 1, wherein:

   the first and second upper electrodes are formed of the light transmissive material; and
   the member is disposed on the first and second upper electrodes.

5. The photoelectric conversion device according to claim 1, wherein:

   the first and second upper electrodes are formed of the light transmissive material;

a transparent resin layer is provided on the first and second upper electrodes; and
the member is disposed on the transparent resin layer.

6. The photoelectric conversion device according to claim 1, wherein:

   the first and second upper electrodes are formed of the light transmissive material;
   a transparent resin layer and a transparent resin substrate are provided on the first and second upper electrodes; and
   the member is disposed on the transparent resin substrate or between the transparent resin layer and the transparent resin substrate.

7. The photoelectric conversion device according to any one of claims 1 to 6, wherein
   the light reflecting material is a metal member or a coating layer of a resin paste containing a metal powder.

8. The photoelectric conversion device according to any one of claims 1 to 6, wherein
   the light scattering material is a metal oxide member or a coating layer of a resin paste containing a metal oxide powder.

9. The photoelectric conversion device according to any one of claims 1 to 6, wherein
   the light absorbing material is a member containing a coloring agent or a coating layer of a resin paste containing the coloring agent.

10. The photoelectric conversion device according to any one of claims 1 to 9, wherein
    the member is provided so that each of a distance from an end portion of the member on the first cell region side to a sidewall of the first groove on the first cell region side, and a distance from an end portion of the member on the second cell region side to a sidewall of the third groove on the first cell region side becomes 0.1 mm or more and 3 mm or less.

# FIG. 1

1

| 3A | 4A | 3B | 4B | 3C |

11 10    11 10

2

5A 6A 7A 8 12 9    5B 6B 7B    8 12 9 5C 6C 7C

# FIG. 2

3

7

63
61   } 6
62

5

# FIG. 3

# FIG. 4

# FIG. 5

# FIG. 6

# FIG. 7

# FIG. 8

3A    4A    3B

d1    9 12 11    d2    10    23 24

7A    7B
6A    6B
5A    5B
22
2

8

# FIG. 9

3A    4A    3B

d1    9 12 11    10    23 24

7A    7B
6A    6B
5A    5B
22
2

8

<table>
<tr><td colspan="2"><strong>INTERNATIONAL SEARCH REPORT</strong></td><td>International application No.<br>PCT/JP2020/010399</td></tr>
</table>

**A. CLASSIFICATION OF SUBJECT MATTER**

Int. Cl. H01L51/44(2006.01)i
FI: H01L31/04 124, H01L31/04 112Z

According to International Patent Classification (IPC) or to both national classification and IPC

**B. FIELDS SEARCHED**

Minimum documentation searched (classification system followed by classification symbols)
Int. Cl. H01L51/42-51/48, H01L31/046-31/0468

Documentation searched other than minimum documentation to the extent that such documents are included in the fields searched
Published examined utility model applications of Japan    1922-1996
Published unexamined utility model applications of Japan   1971-2020
Registered utility model specifications of Japan           1996-2020
Published registered utility model applications of Japan   1994-2020

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y<br>A | JP 2014-120715 A (MITSUBISHI ELECTRIC CORP.) 30 June 2014, paragraphs [0001]-[0015], [0019]-[0094], fig. 1-6 | 1-2, 4-5, 7-9<br>3, 6, 10 |
| Y | WO 2017/057313 A1 (KYUSHU UNIVERSITY) 06 April 2017, paragraphs [0001]-[0003] | 1-2, 4-5, 7-9 |
| Y | WO 2019/022606 A1 (NEDERLANDSE ORGANISATIE VOOR TOEGEPAST-NATUURWETENSCHAPPELIJK ONDERZOEK TNO) 31 January 2019, page 7, line 16 to page 9, line 14, fig. 1 | 1-2, 4-5, 7-9 |
| Y | JP 9-184912 A (TORAY INDUSTRIES, INC.) 15 July 1997, paragraph [0023] | 8-9 |

☐ Further documents are listed in the continuation of Box C.      ☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>27.04.2020 | Date of mailing of the international search report<br>12.05.2020 |
|---|---|
| Name and mailing address of the ISA/<br>    Japan Patent Office<br>    3-4-3, Kasumigaseki, Chiyoda-ku,<br>    Tokyo 100-8915, Japan | Authorized officer<br><br>Telephone No. |

Form PCT/ISA/210 (second sheet) (January 2015)

**INTERNATIONAL SEARCH REPORT**

Information on patent family members

| Patent Documents referred to in the Report | Publication Date | Patent Family | Publication Date |
|---|---|---|---|
| JP 2014-120715 A | 30.06.2014 | (Family: none) | |
| WO 2017/057313 A1 | 06.04.2017 | JP 2017-69533 A | |
| WO 2019/022606 A1 | 31.01.2019 | EP 3435424 A1 | |
| JP 9-184912 A | 15.07.1997 | (Family: none) | |

International application No.

PCT/JP2020/010399

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6030176 B


**Non-patent literature cited in the description**

- **H. TSAI et al.** *Science,* 2018, vol. 360, 67